Europäisches Patentamt

European Patent Office

Office européen des brevets

(19)

(11) Publication number : **0 460 818 A2**

# (12) EUROPEAN PATENT APPLICATION

(21) Application number : **91304404.6**

(22) Date of filing : **16.05.91**

(51) Int. Cl.⁵ : **H04B 1/04**

(30) Priority : **05.06.90 FI 902812**

(43) Date of publication of application :
**11.12.91 Bulletin 91/50**

(84) Designated Contracting States :
**AT BE CH DE DK ES FR GB GR IT LI LU NL SE**

(71) Applicant : **HEIKKI MARTTILA OY**
**Vasarakatu 24**
**SF-40320 Jyväskylä (FI)**

(72) Inventor : **Vesterinen, Jukka**
**Puistokatu 1 B 6**
**SF-444150 Äänekoski (FI)**

(74) Representative : **Barlow, Roy James et al**
**J.A. KEMP & CO. 14, South Square, Gray's Inn**
**London WC1R 5LX (GB)**

(54) **Method for preventing the oscillation of an RF power module.**

(57)   The invention relates to a method and a circuit arrangement for preventing the oscillation of a radio frequency power module (IC1). According to the method of the invention a coupling element (Q7), preferably a bipolar transistor, which is made conductive when the input signal (IN) is removed, is installed between the input (IN) and the ground. The supply voltage (VS) in the power module can be permanently switched on.

Fig 1

EP 0 460 818 A2

The invention relates to a method and a circuit arrangement for preventing the oscillation of a high frequency power module, specially relating to radiotelephone sets.

In radiotelephone transmitter sets, e.g. in portable or mobile telecommunications equipment, a transmitting circuit can use an integrated radio frequency (RF) power amplifier module, which operates for example on a wideband basis on HF, VHF or UHF ranges.

The operation of such a power module is controlled by an input signal, i.e. a power adjusting control, when the set is in an active transmitting state. Control is not being fed to the power module while it is in a stand-by state, i.e. the module is in an uncontrolled state. In this case the module may start to oscillate. The potential oscillation has to be prevented because of the problems caused by oscillation.

In the conventional method the supply voltage of the power module has been under control, i.e. the supply voltage has been disconnected when the control has been removed from the module. Such operation requires, however, switching off high current and accordingly providing costly switching components, which are high current resistant.

The object of the invention is to provide a simple and advantageous method for preventing the oscillation of a radio frequency power module when the input signal, i.e. the control is removed therefrom.

This purpose is achieved according to the invention by the method according to the features of Claim number 1. The method according to the invention can be implemented in a simple manner and using advantageous components. Furthermore, according to the invention, the supply voltage in the power module can be permanently switched on.

Other preferred embodiments of the invention are described in the dependent claims.

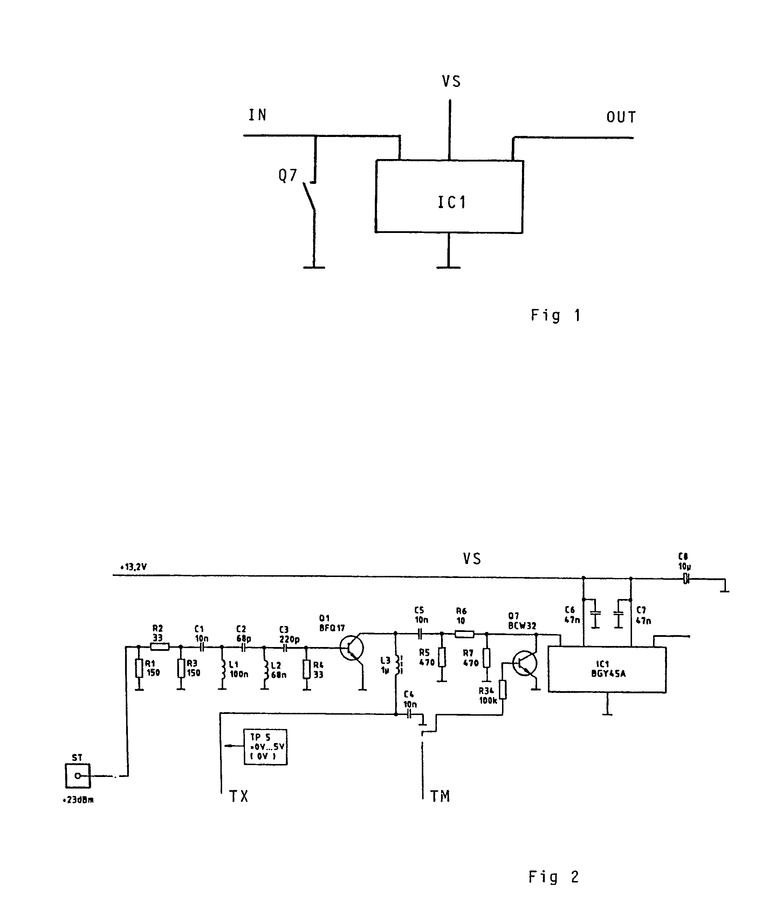

The invention is described in the following by an exemplary embodiment with reference to the accompanying drawing, in which Fig. 1 shows diagrammatically the method according to the invention implemented by the circuit arrangement, and Fig. 2 shows a more detailed implementation of the circuit arrangement illustrated in Fig. 1.

A radio frequency power module IC1 is illustrated in Fig. 1. The supply voltage is VS, the input signal, i.e. the power adjusting control is indicated by IN, and the amplified output of the power signal generated by the power module, respectively, is indicated by OUT. According to the method of the invention a coupling element Q7, preferably a bipolar transistor, which is made conductive when the input signal IN is removed, is installed between the input and the ground. The transistor Q7 is made unconductive when the input signal is active. Since the power levels used in the input are in the range of 1/1000 of the power level of the output and of the input power VS, respectively, it is clear that the coupling element Q7 can be chosen as a much more advantageous low-power component than the power switch which can be used to control the supply voltage.

A more detailed circuit arrangement is illustrated in Fig. 2, where the power module IC1 is of type BGY45A with a frequency range between 68...88 MHz, a supply voltage of 10...15 V and a nominal output power of 29 W. The input is controlled by power level of 10...150 mW. The manufacturer of this circuit discloses that the power module should be stable i.e. non-oscillating also without control, i.e. when the input power = 0,0 mW. Practise has proven, however, that oscillation occurs, which can be prevented according to the invention by the arrangement of the input with the bipolar transistor Q7.

The transistor Q1 in Fig. 2 operates as a power control unit. By adjusting its operating voltage the RF input signal coming to the power module IC1 is changed. When the module is not controlled, i.e. the control signal TX of Q1 = off, Q7 is placed into a conductive state by connecting e.g. a voltage of +5 V via resistor R34 into its base (TM=on). When the module is given control power (TX=on), Q7 is made unconductive by connecting a voltage of 0 V via R34 to its base (TM=off).

Preferably a logical circuit (not shown) is arranged to control the control signals TX and TM so that TM is a logical negation of signal TX (TM = $\overline{TX}$).

## Claims

1. A method for preventing the oscillation of an RF power module, **characterized** in that the input (IN) of the module (IC1) is connected (Q7) to the ground, when the control is switched off, and that the ground connection is switched off when the control is switched on.

2. A method according to Claim 1, **characterized** in that the operating voltage (VS) of the module (IC1) is permanently connected during operation.

3. A method according to the preceding Claims, **characterized** in that the control (TX) of the input of the module (IC1) and the ground connection is controlled (TM) essentially simultaneously by a common circuit.

4. A circuit arrangement for preventing the oscillation of an RF power module when the operating voltage of the module is permanently connected during operation, **characterized** in that it comprises a coupling element (Q7) connected to (IC1) the input, with the coupling element, owing to a signal (TM) in its control input, grounding the input of the module when the control (TX) of the module is switched off, and switches the ground connection off when the control of the module is switched on.

5. A circuit arrangement according to Claim 4, **characterized** in that the signal (TM) of the control input of the coupling element (Q7) and the control (TX) of the module (IC1) are formed via a common circuit, whereby the signal of the control input of the coupling element is essentially a logical negation of the control signal of the module ($TM = \overline{TX}$).

6. A circuit arrangement according to Claim 4 or 5, **characterized** in that the coupling element (Q7) is a low-power transistor.

VS

IN

OUT

Q7

IC1

Fig 1

VS

+13,2V

C8
10µ

R2
33

C1
10n

C2
68p

C3
220p

Q1
BFQ17

C5
10n

R6
10

Q7
BCW32

C6
47n

C7
47n

R1
150

R3
150

L1
100n

L2
68n

R4
33

L3
1µ

R5
470

R7
470

IC1
BGY45A

C4
10n

R34
100k

ST

TP 5
+0V...5V
( 0V )

TX

TM

+23dBm

Fig 2